# EUROPÄISCHE PATENTSCHRIFT

(11) **EP 3 520 134 B1**
(45) Veröffentlichungstag und Bekanntmachung des Hinweises auf die Patenterteilung: **04.11.2020**
(21) Anmeldenummer: 17776987.4
(22) Anmeldetag: 22.09.2017
(51) Int. Cl.: H01L 21/677, H05K 13/02, H01L 21/683, H01L 23/00, H01L 21/68, H01L 21/67

(54) **VORRICHTUNG UND VERFAHREN ZUM BERÜHRUNGSLOSEN ÜBERTRAGEN VON ZUMINDEST TEILWEISE FERROMAGNETISCHEN ELEKTRONISCHEN BAUTEILEN VON EINEM TRÄGER ZU EINEM SUBSTRAT**
APPARATUS AND METHOD FOR CONTACTLESS TRANSFER OF AT LEAST PARTLY FERROMAGNETIC ELECTRONIC COMPONENTS FROM A CARRIER TO A SUBSTRATE
APPAREIL ET MÉTHODE POUR LE TRANSFERT SANS CONTACT DE COMPOSANTS FERROMAGNÉTIQUES ÉLECTRONIQUES D'UN SUBSTRAT PORTEUR VERS UN SUBSTRAT RÉCEPTEUR

(30) Priorität: 29.09.2016 DE 102016011747
(43) Veröffentlichungstag der Anmeldung: 07.08.2019
(73) Patentinhaber: Mühlbauer GmbH & Co. KG, 93426 Roding (DE)
(72) Erfinder: MONSER, Hans-Peter, 01277 Dresden (DE); NIKLAS, Sigmund, 93199 Zell (DE)
(74) Vertreter: Schmidt, Steffen J.
(86) Internationale Anmeldenummer: PCT/EP2017/074044
(87) Internationale Veröffentlichungsnummer: WO 2018/060083

(56) Entgegenhaltungen:
- WO-A1-2015/085064
- CN-A- 105 493 257
- US-A- 3 918 146
- US-A- 6 049 974
- US-A1- 2004 111 875
- US-A1- 2011 262 258
- US-A1- 2011 291 302
- US-A1- 2016 155 892
- RAMADAN QASEM ET AL: "Large scale microcomponents assembly using an external magnetic array", APPLIED PHYSICS LETTERS, A I P PUBLISHING LLC, US, Bd. 90, Nr. 17, 23. April 2007 (2007-04-23), Seiten 172502-172502, XP012094369, ISSN: 0003-6951, DOI: 10.1063/1.2731708

## Beschreibung

### Hintergrund

Hier werden eine Vorrichtung und ein Verfahren zum berührungslosen Übertragen von zumindest teilweisen ferromagnetischen elektronischen Bauteilen von einem Träger hin zu einer vorbestimmten Stelle auf einem Substrat beschrieben. Aspekte der Vorrichtung und des Verfahrens sind sowohl in der Beschreibung, als auch in den Figuren und den Ansprüchen definiert.

Beim Übertragen von elektronischen Bauteilen, insbesondere Chips (engl.: "dies") und insbesondere beim Übertragen von vereinzelten elektronischen Bauteilen besteht allgemein das Problem, dass die elektronischen Bauteile einer kontinuierlichen Miniaturisierung unterworfen sind, wobei die Anforderungen hinsichtlich der Genauigkeit der Platzierung beim Übertragen der elektronischen Bauteile von dem Träger zu dem Substrat kontinuierlich steigen.

Nicht zuletzt aufgrund der besonders hohen Anforderungen an verunreinigungsfreie Fertigungstechniken in der Chipherstellung und aus Gründen der Zeiteffizienz bezogen auf den Fertigungsprozess ist eine berührungslose Übertragungsmethode für elektronische Bauteile von Vorteil. Verfahren zur berührungslosen Montage elektronischer Bauteile haben sich jedoch auf Grund einer zu ungenauen Platzierung der Bauteile auf dem Zielsubstrat nicht durchsetzen können.

### Stand der Technik

Elektronische Bauteile mit zumindest teilweise ferromagnetischen Eigenschaften sind als Stand der Technik bekannt, z. B. Chips mit sogenannten NI/AU-Anschlussflächen (engl.: Bumps).

Darüber hinaus ist z. B. im Zusammenhang mit RFID-Chips ein Verfahren bekannt, bei welchem erhabene Anschlussflächen durch großflächige Metallisierungen ersetzt werden. In einem solchen Fall besteht die Möglichkeit, z. B. Nickel als einen ferromagnetischen Bestandteil der Metallisierungsschichten einzusetzen.

US 8,119,427 B1 offenbart eine Vorrichtung und ein Verfahren zur temporären Fixierung einer LED an einer gewünschten Position mittels eines Magneten, während parallel andere Arbeitsschritte ausgeführt werden, insbesondere das Ausgießen des die LED umgebenden Werkstücks mit Epoxidharz.

JP 2006,31387 1A offenbart eine Vorrichtung und ein Verfahren zur Justierung von elektronischen Bauteilen auf einem Zwischenträger oder Substrat mit Hilfe der magnetischen Eigenschaften der Bauteile.

US 3,918,146 A veranschaulicht den Gegenstand des Oberbegriffs des Anspruchs 1.

Die US 2011/0291302 betrifft ein Verfahren mit den Schritten:
Erzeugen einer Struktur an dem Träger, wobei die Struktur dazu geeignet ist, ein elektronisches Bauteil an ihr auszurichten, so dass das elektronische Bauteil relativ zu der Struktur eine gewünschte Ziellage einnehmen kann, Beschicken der Struktur mit einem Stoff zur Bildung eines Flüssigkeitsmeniskus, wobei der Flüssigkeitsmeniskus zur wenigstens teilweisen Aufnahme des elektronischen Bauteils geeignet ist, Bereitstellen eines Vorrates mit einer Vielzahl der elektronischen Bauteile bei einer Abgabestelle für die elektronischen Bauteile, Bewegen des Trägers mit der Struktur zumindest in die Nähe gegenüber der Abgabestelle, berührungsloses Abgeben eines der elektronischen Bauteile von der Abgabestelle, während sich die Struktur an dem Träger nahe der Abgabestelle befindet, derart, dass das elektronische Bauteil, nachdem es den Vorrat verlassen hat, von keiner mechanischen Einrichtung mechanisch gehalten oder geführt wird, so dass das elektronische Bauteil nach einer Freiphase den Stoff zumindest teilweise berührt, Bewegen des Trägers mit der Struktur zu einer nachgeordneten Verarbeitungsstelle, während das elektronische Bauteil sich auf dem Flüssigkeitsmeniskus an der Struktur selbst ausrichtet, um seine Ziellage einzunehmen, und Befestigen des elektronischen Bauteils auf dem Träger an der Struktur mit dem zumindest teilweise zwischen der Struktur und dem elektronischen Bauteil verbleibenden Stoff. Bei der Abgabestelle befindet sich eine Laserlichtquelle zum Initiieren eines berührungslosen Abgebens eines der Bauteile von der Abgabestelle.

Die Dokumente CN105493257-A, US2011/0262258-A1, US2004/0111875-A1 und WO2015/085064-A1 offenbaren weitere Vorrichtungen und Verfahren aus dem Stand der Technik.

### Problem

Somit besteht die Aufgabe, eine Vorrichtung und ein Verfahren zum berührungslosen Übertragen eines zumindest teilweise ferromagnetischen elektronischen Bauteils von einem Träger hin zu einem Substrat mit hoher Präzision und hoher Geschwindigkeit bereitzustellen.

### Vorgeschlagene Lösung

Zur Lösung dieser Aufgabe wird eine Vorrichtung zum berührungslosen Übertragen eines zumindest teilweise ferromagnetischen elektronischen Bauteils von einem Träger zu einem Substrat vorgeschlagen. Dabei umfasst die Vorrichtung die Merkmale des Patentanspruchs 1.

### Eigenschaften, Vorteile und Varianten

Die hier offenbarte und beanspruchte Anordnung erlaubt es, die Präzision gegenüber bekannten berührungslosen Übertragungsverfahren signifikant zu erhöhen. Durch die vorliegende Anordnung ist ein physisches Berühren der zumindest teilweise ferromagnetischen Bauteile zur genauen Positionierung auf einem Substrat nicht mehr nötig. Bei Raumtemperatur haben bestimmte Metalle immer ferromagnetische Eigenschaften. Beispiele hierfür sind Eisen, Nickel oder Kobalt. Elektronische Bauteile sind zumeist zumindest teilweise nickelhaltig. Auch besteht die Möglichkeit bei der Herstellung von elektronischen Bauteilen Nickel gezielt hinzuzufügen, um ferromagnetische Eigenschaften herbeizuführen. Verglichen mit ähnlich präzisen bekannten Verfahren ist eine signifikante Erhöhung der Übertragungsgeschwindigkeit der Bauteile verbunden, da keine mechanischen Positionierungswerkzeuge mehr bewegt werden müssen. Mit der vorliegenden Anordnung ist sowohl eine hohe Transferrate als auch eine hohe Platzierungsgenauigkeit erzielbar.

Die Magnetanordnung kann, je nach Ausführungsvariante, sowohl eine sehr einfache Magnetanordnungen (im einfachsten Fall ein einzelner Dauermagnet), als auch eine komplexe Magnetanordnung mehrerer, durch eine Steuereinheit voneinander unabhängig über ihre Stromversorgung steuerbarer Elektromagneten sein. So ist auch ein Übertragungsweg vom Träger zum Substrat möglich, der nicht gleichgerichtet mit der Erdanziehungskraft ist. Auch eine Kombination von Permanentmagneten und Elektromagneten ist möglich.

In einer Variante sind Magnete der Magnetanordnung jeweils durch Magnetjustierung- oder Positionierungseinrichtungen, zumindest in einem begrenzten Bereich, zu verschieben und/oder zu verschwenken.

In einer Variante sind die Bauteile mit einem thermisch deaktivierbaren Haftmittel am Träger befestigt. Dies erlaubt den Einsatz einer Anordnung, in welcher die Ablöseeinheit zum Ablösen der Bauteile vom Träger eine in ihrer Intensität steuerbare Wärmequelle, insbesondere ein Laser ist.

In einer Variante ist das Bauteil mit einem durch UV-Bestrahlung (ultraviolettes Licht) in seiner Haftkraft reduzierbaren Haftmittel am Träger befestigt. Der Laser ist dazu ausgebildet und angeordnet, das Ablösen der Bauteile durch Verdampfen der unmittelbaren Grenzschicht des Haftmittels an den Bauteilen zu bewirken.

In einer Variante ist eine Maske zwischen dem abgebenden Träger und dem Laser positioniert. Diese Maske ist dazu ausgebildet und angeordnet, die Geometrie eines Laserstrahls der Grundfläche der auf dem Träger befindlichen Bauteile anzupassen.

Der Laser ist als stationäre Ablöseeinheit implementiert und lediglich der von der Ablöseeinheit emittierte Laserstrahl wird durch eine Spiegelanordnung an eine vorgegebene Stelle reflektiert. Die Spiegelanordnung besteht hierbei aus einem oder mehreren Spiegeln, welche jeweils dazu ausgebildet und angeordnet sind durch Spiegelpositionierungsaktoren, zumindest in einem beschränkten Bereich verschoben und/oder verschwenkt zu werden.

In einer Variante ist die Aufnahme für den Träger dazu ausgebildet und angeordnet, durch einen ersten Aktor, zumindest in einem bestimmten Bereich verschoben und/oder verschwenkt zu werden.

In einer Variante ist die Aufnahme für das Substrat dazu ausgebildet und angeordnet, durch einen zweiten Aktor, zumindest in einem bestimmten Bereich verschoben und/oder verschwenkt zu werden.

In weiteren Ausführungsbeispielen kann die Aufnahme für das Substrat auch eine Montagelinie, insbesondere ein Fließband sein, auf der eine Vielzahl von Substrateinheiten am Träger, entweder kontinuierlich oder sukzessive zum Zwecke der Positionierung je eines oder mehrerer ferromagnetischer elektronischer Bauteile vorbeigeführt werden.

In einer Variante ist die zweite Aufnahme für das Substrat dazu ausgebildet und angeordnet, das Substrat sukzessive oder kontinuierlich relativ zur ersten Aufnahme für den Abgebenden Träger zu bewegen, wobei das Substrat eine Mehrzahl von vorbestimmten Stellen zur Aufnahme von Bauteilen aufweist. Das Substrat wird hierbei über eine Auflage geführt, welche das Substrat von der dem Bauteil abgewandten Seite her stützt und dadurch einer präzisen Positionierung der Bauteile zuträglich ist. Auch kann zumindest ein Teil der Magnetanordnung in einer hierfür vorgesehenen Aufnahmeeinrichtung der Auflage zumindest teilweise untergebracht oder integriert sein. Die Auflage selbst besitzt hierbei keine ferromagnetischen Eigenschaften; vielmehr ist die Auflage unmagnetisch und magnetisch durchlässig.

In einer anderen Variante kann die Magnetanordnung durch eine hierzu geeignete Magnethalterung unterhalb der Auflage positioniert sein. Auch in dieser Variante können Magnete der Magnetanordnung jeweils durch Magnetjustierungs- oder Positionierungseinrichtungen, zumindest in einem begrenzten Bereich, zu verschieben und/oder zu verschwenken sein. Insbesondere kann die Magnethalterung mit der Magnetanordnung als Ganzes durch Magnetjustierungs- oder Positionierungseinrichtungen, zumindest in einem begrenzten Bereich, zu verschieben und/oder zu verschwenken sein. Die Magnethalterung kann zum Bespiel als schwenkbarer und/oder verschiebbarer Haltearm ausgebildet sein.

In einer Variante ist das Substrat dazu ausgebildet und angeordnet schrittweise oder kontinuierlich von einer ersten Rolle zu einer zweiten Rolle bewegt und dabei über die Auflage geführt zu werden. Hierbei können die Chips vor dem Aufrollen durch eine Aushärtestation, an deren Stelle die Geschwindigkeit des Substrattransports von der Geschwindigkeit des Substrats beim Ablösen des Chips entkoppelt sein kann, ausgehärtet werden, insbesondere durch Thermokompression oder durch Druck und/oder UV-Licht.

In einer Variante umfasst die Vorrichtung einen ersten Sensor, insbesondere einen bildgebenden Sensor, welcher dazu ausgebildet und angeordnet ist, eine Position des Bauteils auf dem Träger direkt und/oder durch das Erfassen einer Referenzmarkierung mit bekannter geometrischer Lage zum Bauteil zu bestimmen.

Da der Laser als Wärmequelle und die Spiegelvorrichtung für die Vorrichtung vorgesehen sind, nutzt der erste Sensor, welcher in dieser Variante insbesondere ein optischer Sensor ist, denselben optischen Strahlengang wie der Laser.

In einer Variante umfasst die Vorrichtung einen zweiten Sensor, insbesondere einen bildgebenden Sensor, welcher dazu ausgebildet und angeordnet ist, eine Position des Bauteils auf dem Substrat direkt und/oder durch das zusätzliche Erfassen einer Referenzmarkierung mit bekannter geometrischer Lage zur vorgesehenen Positionierungsstelle des Bauteils zu bestimmen.

In einer Variante umfasst die Vorrichtung eine programmierbare Steuereinheit mit Speicherfunktion (engl.: "Electronic Control Unit" / ECU), welche dazu ausgebildet und angeordnet ist, die Informationen der Sensoren auszuwerten und zu speichern. Mit Hilfe der Sensorinformationen sowie gespeicherter Positionsdaten der Hilfsmarkierungen und einer extern zugeführten oder gespeicherten Information, welche eine Auswahl der zu übertragenen Bauteile enthält, ermöglicht die ECU die Steuerung der Aktoren der beiden Aufnahmen, des Positionierungsaktors, der Intensität der Ablöseeinheit, der Spiegelpositionierungsaktoren, der Magnetjustierung- oder Positionierungseinrichtungen, sowie der voneinander unabhängigen Stromversorgungen der Elektromagnete.

Im Übrigen wird ein Verfahren zum Übertragen eines zumindest teilweise ferromagnetischen elektronischen Bauteils von einem Träger hin zu einem Substrat offenbart und beansprucht.

Das Verfahren umfasst die Schritte des Anspruchs 9:
Das magnetische Feld wird durch eine Magnetanordnung hervorgerufen. Je nach Ausführungsvariante kann diese gleichermaßen durch eine sehr einfache Magnetanordnung (in einfachsten Fall ein einzelner Permanentmagnet), als auch eine komplexe Magnetanordnung mehrerer durch eine Steuereinheit voneinander unabhängig gesteuerter Elektromagneten hervorgerufen werden. Auch eine Kombination von Permanentmagneten und Elektromagneten ist möglich.

In einer Variante werden ein oder mehrere Elektromagnete über eine von je einem oder mehreren weiteren Elektromagneten getrennt regelbare Stromversorgung gesteuert. Hierdurch werden Übertragungswege realisiert, welche nicht gleichgerichtet zur Erdanziehungskraft verlaufen.

Eine Variante des Verfahrens bedient sich einer Anordnung einer Mehrzahl von Permanentmagneten oder Elektromagneten unterschiedlicher Stärke oder einer Anordnung einer Mehrzahl von Elektromagneten unterschiedlicher Steuerung, welche ein inhomogenes Magnetfeld hervorruft. Dieses wirkt einer Rotation des Bauteils während des Übertragungsvorgangs - ausgelöst zum Beispiel durch ein ungleichmäßiges Ablösen des Bauteils von der Haftfolie - entgegen.

In einer Variante werden einzelnen Magnete der Magnetanordnung durch Magnetjustierung- oder Positionierungseinrichtungen, zumindest in einem begrenzten Bereich, verschoben und/oder verschwenkt.

Das Bauteil ist mit einem thermisch deaktivierbaren Haftmittel am Träger befestigt und das Ablösen der Bauteile vom Träger erfolgt durch einen in seiner Intensität steuerbaren Laser.

In einer Variante ist das Bauteil mit einem durch UV-Bestrahlung in seiner Haftkraft reduzierbaren Haftmittel am Träger befestigt. Die Intensität des steuerbaren Lasers löst die Bauteile durch Verdampfen der unmittelbaren Grenzschicht des Haftmittels an den Bauteilen vom Träger ab.

In einer Variante ist eine Maske zwischen dem abgebenden Träger und dem Laser positioniert. Diese Maske passt die Geometrie eines Laserstrahls der Grundfläche der auf dem Träger befindlichen Bauteile an.

Der Laser ist als stationäre Ablöseeinheit implementiert und lediglich der von der Ablöseeinheit emittierte Laserstrahl wird durch eine Anordnung beweglicher Spiegel an eine vorgegebene Stelle reflektiert. Die Spiegelanordnung besteht hierbei aus einem oder mehreren Spiegeln, welche durch Spiegelpositionierungsaktoren, zumindest in einem beschränkten Bereich, verschoben und/oder verschwenkt werden.

In einer Variante umfasst das Verfahren einen ersten Sensor, insbesondere einen bildgebenden Sensor, welcher eine Position des Bauteils auf dem Träger direkt und/oder durch das Erfassen einer Referenzmarkierung mit bekannter geometrischer Lage zum Bauteil bestimmt.

In einer Variante, welche einen Laser als Wärmequelle und eine Spiegelvorrichtung für das Verfahren vorsieht, nutzt der erste Sensor, welcher in dieser Variante insbesondere ein optischer Sensor ist, denselben optischen Strahlengang wie der Laser.

In einer Variante umfasst die Vorrichtung einen zweiten Sensor, insbesondere einen bildgebenden Sensor, welcher eine Position des Bauteils auf dem Substrat direkt und/oder durch das zusätzliche Erfassen einer Referenzmarkierung mit bekannter geometrischer Lage zur vorgesehenen Positionierungsstelle des Bauteils bestimmt.

In einer Variante umfasst die Vorrichtung eine programmierbare Steuereinheit mit Speicherfunktion (engl.: "Electronic Control Unit" / ECU), welche die Informationen der Sensoren auswertet und speichert. Mit Hilfe der Sensorinformationen sowie gespeicherter Positionsdaten der Hilfsmarkierungen und einer extern zugeführten oder gespeicherten Information, welche eine Auswahl der zu übertragenen Bauteile enthält, steuert die ECU die Aktoren der beiden Aufnahmen, die Intensität der Ablöseeinheit, die Spiegelpositionierungsaktoren, die Magnetjustierung- oder Positionierungseinrichtungen, sowie die voneinander unabhängigen Stromversorgungen der Elektromagnete.

### Kurzbeschreibung der Zeichnungen

Fig. 1 ist eine schematische Darstellung eines Ausführungsbeispiels der Vorrichtung mit einem Laser und einem einzelnen Permanentmagneten.
Fig. 2 ist eine schematische Darstellung eines Ausführungsbeispiels der Vorrichtung mit einem positionierbaren Laser und einer Anordnung mehrerer über ihre Stromversorgung gesteuerter Elektromagnete.
Fig. 3 ist eine schematische Darstellung eines Ausführungsbeispiels der Vorrichtung mit einem stationären Laser, einem positionierbaren Spiegel und einer Anordnung mehrerer über ihre Stromversorgung gesteuerter, teilweise positionierbaren Elektromagnete.
Fig. 4 ist eine schematische Darstellung der Steuerung als Blockschaltbild.

### Detaillierte Beschreibung der Zeichnungen

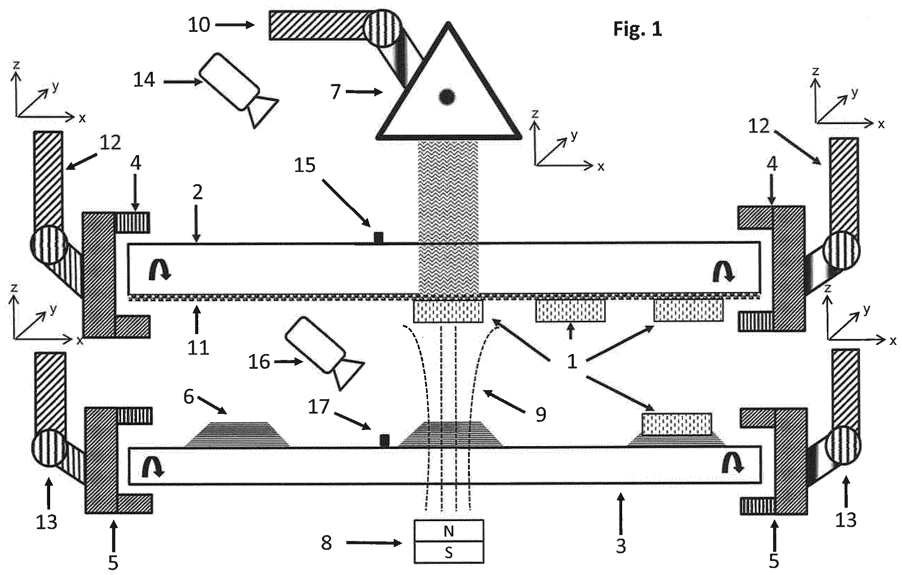

Die in Fig. 1 gezeigte Vorrichtung zeigt schematisch (im Querschnitt) eine gabelförmige Aufnahme 4, die eine in einem Spannring befindliche Waferfolie 2 aufnimmt, indem sie den Spannring lediglich an zwei je gegenüberliegenden Kontaktstellen mit je einer Halteklemme fixiert. Weder die Vorderseite der Waferfolie 2, auf der die Bauteile 1 angebracht sind, noch die gegenüberliegende Rückseite sind durch die gabelförmige Aufnahme 4 verdeckt.

Bei der in Fig. 1 gezeigten Variante handelt es sich bei den zumindest teilweise ferromagnetischen elektronischen Bauteilen 1 um Chips mit sogenannten Ni/Au-Anschlussflächen.

Die im Weiteren als Chips bezeichneten Bauteile 1 befinden sich auf der Vorderseite der Waferfolie 2 und sind dort mit einer thermisch deaktivierbaren Haftfolie 11 ("Thermal Release Tape") befestigt.

In anderen Ausführungsformen können alle anderen Arten von Trägern elektronischer Bauteile, die in den Fertigungsprozessen der Halbleitertechnik Anwendung finden, anstelle der hier beschriebenen Waferfolie 2 verwendet werden. Die elektronischen Bauteile können mit einem Haftmittel, insbesondere mit einem thermisch deaktivierbaren Haftmittel an den jeweiligen Trägern befestigt sein, jedoch ist dies nicht in jeder Ausführungsform erforderlich. Auch das Verdampfen einer Grenzschicht zwischen dem elektronischen Bauteil und einer Waferfolie ist in einer Ausführungsform vorgesehen.

In einer Ausführungsform kann die Haftfolie auch durch UV-Bestrahlung ihre Haftkraft zum Chip hin reduzieren, wobei der hiermit verbundene Wärmeeintrag die Haftung komplett aufhebt.

Auch können andere Ausführungsformen Aufnahmen oder Halterungen beinhalten, die eine Waferfolie oder einen Träger vollständig oder zumindest in Teilen entlang seines Außenrandes mit unterschiedlichen Befestigungstechniken fixieren. Auch sind Ausführungsformen möglich, die eine Waferfolie oder einen Träger zusätzlich oder ausschließlich an Kontaktstellen berühren, welche nicht an seinem Außenrand positioniert sind. Eine teilweise Verdeckung zumindest einer der Waferfolien- oder Trägerseiten durch eine Aufnahme oder Halterung kann in anderen Ausführungsformen auftreten.

In der hier in Fig. 1 gezeigten Ausführungsform wird die gabelförmige Aufnahme 4 durch einen Aktor 12, zumindest in einem Arbeitsbereich, frei im Raum bewegt, wobei der Aktor 12 hier einen dreidimensional schwenkbaren elektrischen Linearantrieb beinhaltet, welcher durch eine Electronic Control Unit (ECU) 18 gesteuert wird. Außerdem beinhaltet der Aktor 12 einen ebenfalls durch die ECU 18 gesteuerten Elektromotor, welcher zumindest bis zu einen bestimmten Winkel eine Drehung der Waferfolie 2 bewirkt, indem er die Halteklemmen, welche zur Fixierung des Spannrings der Waferfolie 2 dienen, rotiert. Die Waferfolie 2 kann hierdurch gekippt werden. Zuletzt beinhaltet der hier beschriebene Aktor 12 eine elektromechanische Komponente, ebenfalls gesteuert durch die ECU 18, welche das Öffnen oder Schließen der Halteklemmen bewirkt.

In anderen Ausführungsformen können eine Vielzahl von weiteren Aktoren zum Einsatz kommen und den elektrischen Linearantrieb sowie den Elektromotor bzw. das elektromechanische Element entweder ersetzen oder ergänzen, insbesondere durch hydraulische oder pneumatische Aktoren oder weitere elektromechanische Elemente. Eine Bewegungsfreiheit in allen drei Raumdimensionen und die Möglichkeit zur Rotation der Waferfolie werden hierbei nicht in allen Ausführungsformen implementiert.

Weiter zeigt Fig. 1 ein Substrat 3, auf welches die Chips 1 übertragen werden. Auf dem Substrat 3 befinden sich an mehreren hierfür vorgesehenen Stellen 6 Metallisierungen und Klebstoff, auf die je ein Chip 1 übertragen wird.

In einer Ausführungsform kann die vorgesehene Stelle 6 auf dem Substrat 3 ein Antennenanschlusspaar einer Antenne oder ein leitfähiges Klebstoffdepot sein.

In anderen Ausführungsformen wird der Chip zunächst auf einen Zwischenträger übertragen. In einer Ausführungsform ist das Substrat ein Zwischenträger mit Strukturierung und ohne Klebstoff. Auch Ausführungsformen, bei denen mehrere Chips von der Waferfolie nebeneinander auf eine vorgesehene Stelle des Substrats übertragen werden, sind möglich. Weiter zeigt Fig.1 - analog zur gabelförmigen Aufnahme 4 die Waferfolie 2 - eine gabelförmige Aufnahme 5, die das Substrat 3 bereithält, indem sie es lediglich an zwei je gegenüberliegenden Kontaktstellen mit je einer Halteklemme fixiert. Weder die Vorderseite des Substrats 3, auf der sich die zur Aufnahme vorgesehenen Stellen 6 befinden, noch die gegenüberliegende Rückseite sind durch die gabelförmige Aufnahme 5 verdeckt.

Andere Ausführungsformen können Aufnahmen oder Halterungen beinhalten, die das Substrat vollständig oder zumindest in Teilen entlang seines Außenrandes mit unterschiedlichen Befestigungstechniken fixieren. Auch sind Ausführungsformen möglich, die das Substrat zusätzlich oder ausschließlich an Kontaktstellen berühren, welche nicht an seinem Außenrand positioniert sind. Eine teilweise Verdeckung, zumindest einer der Substratseiten durch eine Aufnahme oder Halterung kann in anderen Ausführungsformen auftreten.

In einer Variante ist das Substrat dazu ausgebildet und angeordnet, schrittweise oder kontinuierlich von einer ersten Rolle zu einer zweiten Rolle bewegt und dabei über die Auflage geführt zu werden. Hierbei kann die zweite Aufnahme insbesondere ein Rollenpaar sein, wobei eine Rolle des Rollenpaares von einem Servomotor angetrieben werden kann.

In der hier in Fig.1 gezeigten Ausführungsform wird die gabelförmige Aufnahme 5 - analog zur gabelförmige Aufnahme 4 der Waferfolie 2 - durch einen Aktor 13, zumindest in einem Arbeitsbereich, frei im Raum bewegt, wobei der Aktor 13 hier einen dreidimensional schwenkbaren elektrischen Linearantrieb beinhaltet, welcher durch die ECU 18 gesteuert wird. Darüber hinaus beinhaltet der Aktor 13 einen ebenfalls über die ECU 18 gesteuerten Elektromotor. Dieser bewirkt, zumindest bis zu einem bestimmten Winkel eine Drehung des Substrats 3, indem er die Halteklemmen, welche zur Fixierung des Substrats 3 dienen, rotiert. Das Substrat kann somit gekippt werden. Zuletzt beinhaltet der hier beschriebene Aktor 13 eine elektromechanische Komponente, ebenfalls gesteuert durch die ECU 18, welche das Öffnen oder Schließen der Halteklemmen bewirkt.

In anderen Ausführungsformen können eine Vielzahl von weiteren Aktoren zum Einsatz kommen und den elektrischen Linearantrieb sowie den Elektromotor bzw. das elektromechanische Element entweder ersetzen oder ergänzen, insbesondere durch hydraulische oder pneumatische Aktoren oder elektromechanische Aktoren. Eine Bewegungsfreiheit in allen drei Raumdimensionen und die Möglichkeit zur Rotation des Substrats werden hierbei nicht immer implementiert.

In der weiteren Beschreibung der Fig 1. wird als gegeben vorausgesetzt, dass zumindest während der Übertragung der Chips 1 die Vorderseite einer Waferfolie 2 jener Seite des Substrats 3 zugewandt ist, auf der sich die vorbereiteten Stellen 6 befinden, unabhängig davon, ob die beschriebenen Aufnahmen 4 und 5 weitere mögliche Anordnungen erlauben.

Weiter zeigt Fig.1 einen in seiner Intensität durch die ECU 18 steuerbaren Laser 7 zum Lösen einzelner Chips 1 von der Haftfolie 11. Hierzu bestrahlt der Laser 7 jeweils die dem Bauteil 1 auf der Rückseite der Waferfolie 2 gegenüberliegende Stelle und erzeugt somit eine punktuell erhöhte Temperatur. Dadurch deaktiviert er die Haftungseigenschaften der Haftfolie 11, welche sich zwischen dem Chip 1 und dem der Waferfolie 2 befindet.

Die Eigenschaften des Lasers 7 erlauben das Ablösen eines einzelnen Chips 1 ohne die Haftungseigenschaften der Haftfolie 11 im Bereich eines zweiten Chips so zu beeinflussen, dass dieser ebenfalls gelöst würde.

Der Laser 7 ist ortsfest montiert. In der in Fig. 1 gezeigten, lediglich dem Verständnis dienenden Variante ist der Laser 7 durch einen Positionierungsaktor 10 beweglich, wobei der Positionierungsaktor 10 hier einen in allen drei Raumdimensionen schwenkbaren, durch die ECU 18 gesteuerten elektrischen Linearantrieb beinhaltet. Der Laser 7 kann hierdurch, zumindest in einem Arbeitsbereich, durch den Positionierungsaktor 10 beliebig positioniert werden. Ein zusätzlich in den Positionierungsaktor 10 integrierter und ebenfalls durch die ECU 18 gesteuerter Elektromotor erlaubt, zumindest bis zu einem gewissen Winkel, die Rotation des Lasers 7 entlang einer Achse orthogonal zum emittierten Laserstrahl. Hierdurch kann der Auftreffwinkel des Laserstrahls auf die Rückseite der Waferfolie 2 beeinflusst werden. Da die Waferfolie 2 wie beschrieben ebenfalls rotiert werden kann, ist diese Funktionalität notwendig um zu vermeiden, dass ein in zu flachem Winkel auf die Waferfolie auftreffender Laserstahl benachbarte Chips durch Erwärmung unbeabsichtigt mit ablöst.

In anderen Ausführungsformen können eine Vielzahl von weiteren Aktoren zum Einsatz kommen und den elektrischen Linearantrieb sowie den Elektromotor entweder ersetzen oder ergänzen, insbesondere durch hydraulische- oder pneumatische Aktoren sowie elektromechanische Aktoren. Eine Bewegungsfreiheit in allen drei Raumdimensionen und die Möglichkeit zur Rotation der Ablöseeinheit werden hierbei nicht immer implementiert.

Fig. 1 zeigt weiterhin einen stationären, unmittelbar unterhalb der vorgesehenen Stelle 6 positionierten Permanentmagneten 8, der ein Magnetfeld 9 hervorruft, welches eine magnetische Kraft auf den Chip 1 ausübt. Diese Kraft zieht den durch den Laser 7 von der Haftfolie 11 abgelösten Chip 1 an, sodass eine Positionierung auf der hierzu vorgesehenen Stelle 6 des Substrats 3 zumindest unterstützt wird. Die magnetische Kraft, welche auf den Chip 1 wirkt, ist hierbei stets von der Waferfolie 2 hin zum Substrat gerichtet.

Weiter zeigt Fig. 1 die zwei Kamerasensoren 14 und 16. Der Kamerasensor 14 bestimmt die Position der Hilfsmarkierung 15 und gibt diese Information an die ECU 18 weiter. Da die geometrische Lage der Hilfsmarkierung 15 auf der Waferfolie 2 der ECU 18 ebenso bekannt ist wie der Rotationszustand der Waferfolie 2, verfügt die ECU 18 somit auch über die Positionsinformation eines jeden Chips 1 auf der Waferfolie 2.

In einer anderen Ausführungsform bestimmt der Kamerasensor 14 die Position eines Chips 1 auf der Waferfolie 2 unmittelbar und ohne Hilfsmarkierung.

Im gezeigten Ausführungsbeispiel werden nur solche Chips 1 von der Waferfolie 2 auf das Substrat 3 übertragen, die in einer vorhergehenden Qualitätskontrolle (welche nicht Teil der hier beschriebenen Vorrichtung ist) als geeignet befunden wurden. Ein Verzeichnis dieser positiv überprüften Chips sowie ihrer geometrischen Lage auf der Waferfolie 2 ist im Speicher der ECU 18 hinterlegt.

Der Kamerasensor 16 bestimmt die Position der Hilfsmarkierung 17 und die Position der zur Übertragung vorgesehenen Stellen 6 auf dem Substrat 3 und gibt diese Information an die ECU 18 weiter. Da die geometrische Lage der Hilfsmarkierung 16 auf dem Substrat 3 der ECU 18 ebenso bekannt ist wie der Rotationszustand des Substrats 3, verfügt die ECU 18 somit auch über die Positionsinformationen jeder einzelnen vorgesehenen Stelle 6 auf dem Substrat 3. Da im vorliegenden Ausführungsbeispiel die vorgesehenen Stellen 6 auch direkt durch den Kamerasensor 16 erfasst werden können, erfolgt nach Abschluss des Übertragungsvorgangs eine Qualitätskontrolle in Bezug auf eine korrekte Positionierung des Chips 1 auf die vorgesehene Stelle 6 des Substrats 3 durch den Kamerasensor 16.

In einer anderen Ausführungsform findet die Qualitätskontrolle ausschließlich durch einen hierfür exklusiv vorgesehenen weiteren Kamerasensor statt.

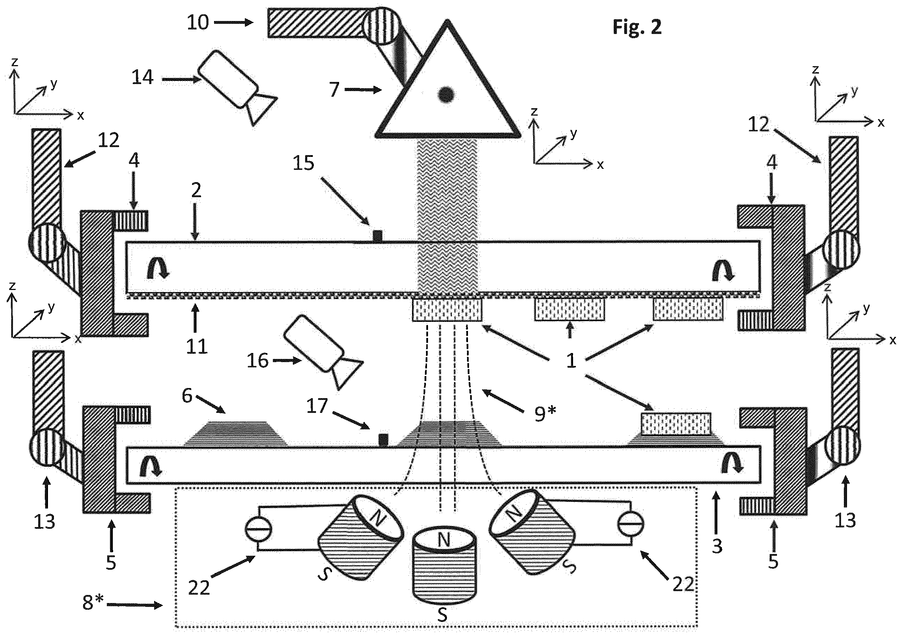

Fig. 2 zeigt einen Aufbau wie Fig. 1 mit der Abwandlung, dass statt des Permanentmagneten 8 eine Anordnung von drei Elektromagneten 8* gezeigt wird.

In anderen Ausführungsformen kann eine beliebige andere Anzahl von Elektro- und/oder Permanentmagneten, insbesondere auch ein einzelner Magnet, verwendet werden.

Die Elektromagnete 8* rufen gemeinsam ein Magnetfeld 9* hervor, welches eine magnetische Kraft auf den Chip 1 ausübt. Diese Kraft zieht den durch den Laser 7 von der Haftfolie 11 abgelösten Chip 1 so an, dass eine Positionierung auf der hierzu vorgesehenen Stelle 6 des Substrats 3 zumindest unterstützt wird.

Jeder der in Fig. 2 gezeigten Elektromagnete 8* ist mit einer jeweils separat durch die ECU 18 regelbaren Stromversorgung 22 verbunden.

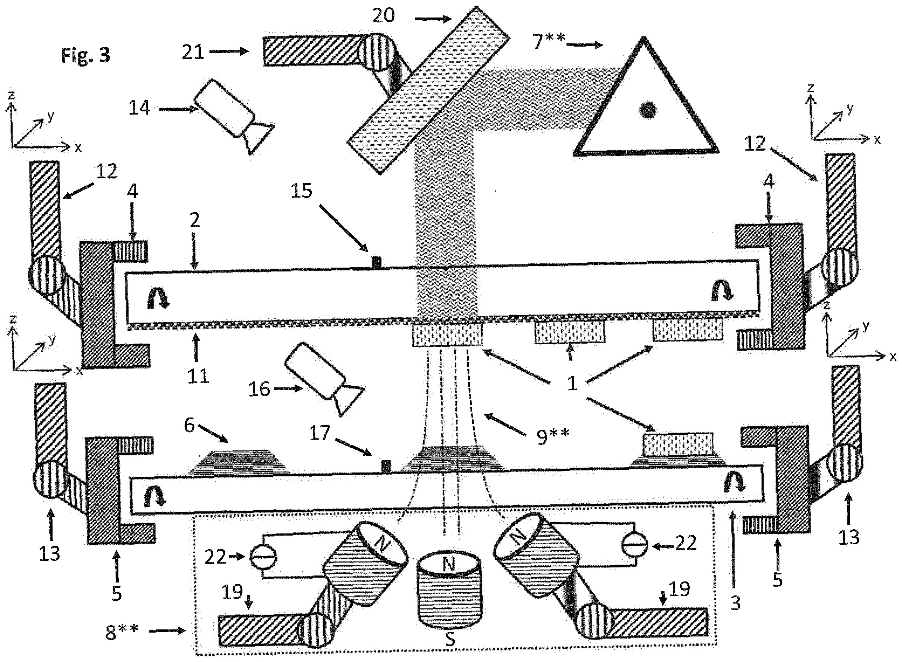

Fig 3. zeigt einen Aufbau wie Fig. 2 mit zwei Varianten (Abwandlung A und Abwandlung B)

### Abwandlung A:

Der Laser 7** ist in Fig. 3 ein stationärer Laser. Der in Fig. 3 gezeigte Spiegel 20 reflektiert den auf ihn gerichteten Laserstrahl auf eine durch die ECU 18 bestimmte Stelle auf der Rückseite der Waferfolie 2. Der Spiegel 20 wird durch einen Spiegelpositionierungsaktor 21, zumindest in einem Arbeitsbereich, frei im Raum bewegt, wobei der Spiegelpositionierungsaktor 21 hier einen dreidimensional schwenkbaren elektrischen Linearantrieb beinhaltet, welcher durch die ECU 18 gesteuert wird. Darüber hinaus beinhaltet der Spiegelpositionierungsaktor 21 einen ebenfalls durch die ECU 18 gesteuerten Elektromotor, welcher zumindest bis zu einen bestimmten Winkel eine Drehung des Spiegels ermöglicht.

### Abwandlung B:

Die Magnetanordnung 8** ersetzt in Fig. 3 die Magnetanordnung 8* aus Fig. 2. Die Magnetanordnung 8** verfügt über alle Merkmale der Magnetanordnung 8*, jedoch sind zusätzlich Teile der Magnetanordnung in Fig. 3 durch die Magnetjustierung- oder Positionierungseinrichtungen 19 positionierbar.

Zwei Magnete der gezeigten Magnetanordnung 8** werden je durch einen Magnetpositionierungsaktor 19, zumindest in einem Arbeitsbereich frei im Raum bewegt, wobei jeder Magnetpositionierungsaktor 19 hier einen dreidimensional schwenkbaren elektrischen Linearantrieb beinhaltet, welcher durch die ECU 18 gesteuert wird. Darüber hinaus beinhaltet jeder Magnetpositionierungsaktor 19 einen ebenfalls über die ECU 18 gesteuerten Elektromotor, welcher, zumindest bis zu einen bestimmten Winkel eine Drehung des jeweiligen Magneten ermöglicht.

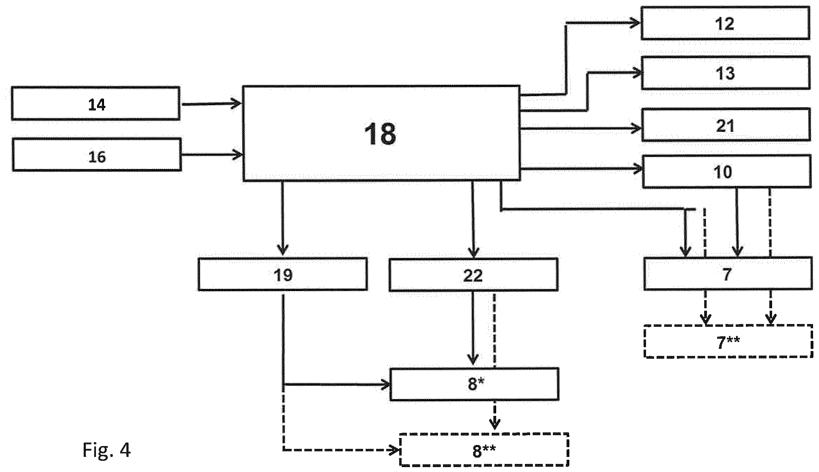

Fig. 4 zeigt ein logisches Schaltbild, welches den Informationseingang und den Steuerungszugriff der ECU 18 schematisch darstellt. Alle in Bezugszeichen beziehen sich auf die vorangegangen Figuren 1 bis 3 und deren Beschreibungen.

Die hier beschriebenen Varianten der Vorrichtung sowie deren Funktions- und Betriebsaspekte dienen lediglich dem besseren Verständnis ihrer Struktur, Funktionsweise und Eigenschaften; sie schränken die Offenbarung nicht etwa auf die Ausführungsformen ein. Die Fig. sind teilweise schematisch, wobei wesentliche Eigenschaften und Effekte zum Teil deutlich vergrößert dargestellt sind, um die Funktionen, Wirkprinzipien, technischen Ausgestaltungen und Merkmale zu verdeutlichen. Dabei kann jede Funktionsweise, jedes Prinzip, jede technische Ausgestaltung und jedes Merkmal, welches/welche in den Fig. oder im Text offenbart ist / sind, mit allen Ansprüchen, jedem Merkmal im Text und in den anderen Fig., anderen Funktionsweisen, Prinzipien, technischen Ausgestaltungen und Merkmalen, die in dieser Offenbarung enthalten sind oder sich daraus ergeben, frei und beliebig kombiniert werden, so dass alle denkbaren Kombinationen den beschriebenen Vorrichtungen zuzuordnen sind. Der Schutzbereich des Patents wird durch die Patentansprüche bestimmt. Die Beschreibung und die Zeichnungen sind jedoch zur Auslegung der Patentansprüche heranzuziehen (Artikel 69(1) EPÜ).

## Patentansprüche

1. Vorrichtung zum Übertragen von zumindest teilweise ferromagnetischen elektronischen Bauteilen (1) von einem abgebenden Träger (2) hin zu einem aufnehmenden Substrat (3), wobei die Vorrichtung umfasst:
eine erste Aufnahme (4) für den abgebenden Träger (2), welcher ausgebildet und angeordnet ist, zumindest teilweise ferromagnetische elektronische Bauteile (1) auf der dem Substrat (3) zugewandten Trägerseite bereitzuhalten, und wobei sich die erste Aufnahme in einem vorbestimmten Abstand zu
einer zweiten Aufnahme (5) für das aufnehmende Substrat (3) befindet, welches ausgebildet und angeordnet ist, eines der Bauteile (1) an einer hierzu auf dem Substrat (3) vorbestimmten Stelle (6) aufzunehmen, und
eine Ablöseeinheit (7, 7**), die ausgebildet und angeordnet ist, ein Ablösen jeweils eines der Bauteile (1) vom Träger (2) zumindest zu unterstützen, um es auf das Substrat (3) zu übertragen, sowie
eine Magnetanordnung (8; 8*; 8**), welche relativ zu der zweiten Aufnahme (5) für das Substrat (3) so zu positionieren ist, dass zumindest während der Übergabe des Bauteils (1) ein von ihr hervorgerufenes magnetisches Feld (9; 9*; 9**) eine magnetische Anziehungskraft, gerichtet vom Träger (2) hin zum Substrat (3), auf das Bauteil (1) ausübt, wobei die Anziehungskraft ein Platzieren des Bauteils (1) auf die hierfür auf dem Substrat (3) vorbestimmte Stelle (6) zumindest unterstützt **dadurch gekennzeichnet, dass** die Ablöseeinheit (7; 7**) zum Ablösen der am Träger (2) befestigten Bauteile (1) vom Träger (2) ein in seiner Intensität steuerbarer Laser ist, und
eine Spiegelanordnung (20) aus einem oder mehreren beweglichen Spiegeln und mindestens ein Spiegelpositionierungsaktor (21) vorgesehen sind, wobei der Spiegelpositionierungsaktor (21) dazu eingerichtet ist, zumindest einen einzelnen Spiegel der Spiegelanordnung (20) zur Reflexion eines emittierten Laserstrahls der Ablöseeinheit (7; 7**) zu verschieben und/oder zu verschwenken.

2. Vorrichtung nach Anspruch 1,wobei die Magnetanordnung (8; 8*; 8**) einen oder mehrere Permanentmagnete und/oder Elektromagnete umfasst, und/oder
weiter umfassend mindestens eine Magnetjustierungs- oder Positionierungseinrichtung (19), welche dazu ausgebildet und angeordnet ist, wenigstens einen Magneten der Magnetanordnung (8**) zu verschieben und/oder zu verschwenken.

3. Vorrichtung nach Anspruch 1, wobei
die zweite Aufnahme (5) für das Substrat (3) dazu ausgebildet und angeordnet ist, das Substrat (3) sukzessive oder kontinuierlich relativ zur ersten Aufnahme (4) für den Abgebenden Träger (2) zu bewegen, wobei
das Substrat (3) eine Mehrzahl von vorbestimmten Stellen (6) zur Aufnahme von Bauteilen (1) aufweist.

4. Vorrichtung nach Anspruch 3, wobei
die dem Bauteil (1) abgewandte Seite des Substrats (3) von der zweiten Aufnahme (5) über eine Auflage geführt wird.

5. Vorrichtung nach Anspruch 3 oder 4, wobei
die Magnetanordnung (8; 8*; 8**) in einer hierfür vorgesehenen Aufnahmeeinrichtung der Auflage zumindest teilweise positioniert ist.

6. Vorrichtung nach einem der vorangegangenen Ansprüche,
weiter umfassend einen ersten Aktor (12), welcher dazu ausgerichtet und angeordnet ist, die erste Aufnahme (4) zu verschieben und/oder zu verschwenken, und/oder
weiter umfassend einen zweiten Aktor (13), welcher dazu ausgerichtet und angeordnet ist, die zweite Aufnahme (5) zu verschieben und/oder zu verschwenken.

7. Vorrichtung nach einem der vorangegangenen Ansprüche,
weiter umfassend einen ersten Sensor (14), insbesondere einen bildgebenden Sensor, welcher ausgebildet und angeordnet ist, eine Position des Bauteils (1) auf dem Träger (2) direkt, und/oder durch das Erfassen einer Referenzmarkierung (15) zu bestimmen, und/oder
weiter umfassend einen zweiten Sensor (16), insbesondere einen bildgebenden Sensor, welcher ausgebildet und angeordnet ist, eine Position des Bauteils (1) auf dem Substrat (3) direkt, und/oder durch das Erfassen einer Referenzmarkierung (17) zu bestimmen.

8. Vorrichtung nach einem der Ansprüche 2 bis 7,
weiter umfassend mindestens eine programmierbare Steuereinheit mit Speicherfunktion (18), welche dazu ausgebildet ist,
die Informationen des ersten Sensors (14) gemäß Anspruch 8 auszuwerten und/oder zu speichern, und/oder
die Informationen des zweiten Sensors (16) gemäß Anspruch 8 auszuwerten und/oder zu speichern, und/oder
den ersten Aktor (12) gemäß Anspruch 7 zu steuern, und/oder
den zweiten Aktor (13) gemäß Anspruch 7 zu steuern, und/oder
jeden Spiegelpositionierungsaktor (21) der Spiegelanordnung (20) gemäß Anspruch 7 jeweils voneinander unabhängig zu steuern, und/oder
die Intensität der Wärmequelle (7; 7**) gemäß Anspruch 6 zu steuern, und/oder
jede Magnetjustierungs- oder Positionierungseinrichtung (19) gemäß Anspruch 2 jeweils voneinander unabhängig zu steuern, und/oder
eine Stromversorgung (22) für jeden Elektromagneten (8*; 8**) gemäß Anspruch 2 jeweils voneinander unabhängig zu steuern.

9. Verfahren zum Übertragen von zumindest teilweise ferromagnetischen elektronischen Bauteilen (1) von einem abgebenden Träger (2) hin zu einem aufnehmenden Substrat (3), wobei das Verfahren durch folgende Schritte gekennzeichnet ist:
- Bereitstellen von zumindest teilweise ferromagnetischen elektronischen Bauteilen (1) auf der dem Substrat (3) zugewandten Seite des Trägers (2),
- Positionierung des Trägers (2) durch eine erste Aufnahme (4) in einem vorbestimmten Abstand zu einer zweiten Aufnahme (5) für das Substrat (3) und in Bezug auf eine Ablöseeinheit (7, 7**) für die Bauteile (1);
- Ablösen jeweils eines der Bauteile (1) vom Träger (2), zumindest unterstützt durch die Ablöseeinheit (7; 7**), um das jeweilige Bauteil (1) vom Träger (2) auf eine hierfür vorbestimmte Stelle (6) des Substrats (3) zu übertragen, wobei die Ablöseeinheit (7; 7**) ein in seiner Intensität steuerbarer Laser zum Ablösen der am Träger (2) befestigten Bauteile (1) vom Träger (2) ist,
- Bereitstellen einer Spiegelanordnung (20) aus einem oder mehreren beweglichen Spiegeln und mindestens eines Spiegelpositionierungsaktor (21), und
Verschieben und/oder Verschwenken zumindest eines einzelnen Spiegels der Spiegelanordnung (20) mittels des Spiegelpositionierungsaktors (21) zur Reflexion eines emittierten Laserstrahls der Ablöseeinheit (7; 7**).
- Anziehen des zumindest teilweise ferromagnetischen elektronischen Bauteils (1) durch eine magnetische Anziehungskraft, welche durch ein magnetisches Feld (9, 9*, 9**) auf das Bauteil (1) ausgeübt wird, wobei das magnetische Feld (9, 9*, 9**) durch eine Magnetanordnung (8; 8*;8**) hervorgerufen wird, die relativ zum in der zweiten Aufnahme (5) befindlichen Substrat (3) so positioniert ist, dass die magnetische Anziehungskraft ein Platzieren des Bauteils (1) auf die hierfür auf dem Substrat (3) vorbestimmte Stelle (6) zumindest unterstützt;
- Aufnahme des Bauteils (1) an der hierzu vorbestimmten Stelle (6) des Substrats (3), welches durch die zweite Aufnahme (5) positioniert ist.

10. Verfahren nach Anspruch 9,
wobei die Magnetanordnung aus einem oder mehreren Magneten und/oder Elektromagneten (8; 8*;8**) gebildet wird, und/oder
wobei wenigstens ein Magnet der Magnetanordnung (8**) durch mindestens eine Magnetjustierungs- oder Positionierungseinrichtung (19) verschoben und/oder verschwenkt werden.

11. Verfahren nach einem der Ansprüche 9 bis 10,
wobei die erste Aufnahme (4) durch einen ersten Aktor (12) verschoben und/oder verschwenkt wird, und/oder
wobei die zweite Aufnahme (5) durch einen zweiten Aktor (13) verschoben und/oder verschwenkt wird.

12. Verfahren nach einem der Ansprüche 9 bis 11,
weiter umfassend einen ersten Sensor (14), insbesondere einen bildgebenden Sensor, welcher eine Position des Bauteils (1) auf dem Träger (2) direkt, und/oder durch das Erfassen einer Referenzmarkierung (15) bestimmt, und/oder
weiter umfassend einen zweiten Sensor (16), insbesondere einen bildgebenden Sensor, welcher eine Position des Bauteils (1) auf dem Substrat (3) direkt, und/oder durch das Erfassen einer Referenzmarkierung (17) bestimmt.

13. Verfahren nach einem der Ansprüche 9 bis 12,
weiter umfassend mindestens eine programmierbare Steuereinheit mit Speicherfunktion (18), welche
die Informationen des ersten Sensors (14) gemäß Anspruch 12 auswertet und/oder speichert, und/oder
die Informationen des zweiten Sensors (16) gemäß Anspruch 12 auswertet und/oder speichert, und/oder
den ersten Aktor (12) gemäß Anspruch 11 steuert, und/oder
den zweiten Aktor (13) gemäß Anspruch 11 steuert, und/oder
jeden Spiegelpositionierungsaktor (21) gemäß Anspruch 11 jeweils voneinander unabhängig steuert, und/oder
die Intensität des Lasers gemäß Anspruch 1 steuert, und/oder
jede Magnetjustierungs- oder Positionierungseinrichtung (19) gemäß Anspruch 10 jeweils voneinander unabhängig steuert, und/oder
eine Stromversorgung (22) für jeden Elektromagneten (8*; 8**) gemäß Anspruch 10 jeweils voneinander unabhängig steuert.

## Claims

1. A device for transferring at least partly ferromagnetic electronic components (1) from a dispensing carrier (2) to a receiving substrate (3), wherein the device comprises:
a first holding fixture (4) for the dispensing carrier (2), which is configured and arranged to hold at least partly ferromagnetic electronic components (1) on the side of the carrier facing the substrate (3), and wherein the first holding fixture is located at a predetermined distance from
a second holding fixture (5) for the receiving substrate (3), which is configured and arranged to receive one of the components (1) at a place (6) predetermined for this on the substrate (3), and
a detachment unit (7, 7**), which is configured and arranged at least to support a detachment of one of the components (1) in each case from the carrier (2), in order to transfer it to the substrate (3), as well as
a magnetic arrangement (8; 8*; 8**), which is to be positioned relative to the second holding fixture (5) for the substrate (3) so that a magnetic field (9; 9*; 9**) produced by it exerts a magnetic attraction force directed from the carrier (2) towards the substrate (3) on the component (1), at least during the transfer of the component (1), wherein the attraction force at least supports a placement of the component (1) onto the place (6) predetermined for this on the substrate (3), **characterized in that**
the detachment unit (7; 7**) for detaching the components (1) attached to the carrier (2) from the carrier (2) is a laser that is controllable in its intensity, and
a mirror arrangement (20) of one or more movable mirrors and at least one mirror positioning actuator (21) are provided, wherein the mirror positioning actuator (21) is adapted to move and/or to swivel at least a single mirror of the mirror arrangement (20) to reflect an emitted laser beam of the detachment unit (7; 7**).

2. The device according to claim 1, wherein
the magnetic arrangement (8; 8*; 8**) comprises one or more permanent magnets and/or electromagnets, and/or
further comprising at least one magnet adjustment or positioning device (19), which is configured and arranged to move and/or to swivel at least one magnet of the magnetic arrangement (8**).

3. The device according to claim 1, wherein
the second holding fixture (5) for the substrate (3) is configured and arranged to move the substrate (3) successively or continuously relative to the first holding fixture (4) for the dispensing carrier (2), wherein
the substrate (3) has a plurality of predetermined places (6) for receiving components (1).

4. The device according to claim 3, wherein
the side of the substrate (3) facing away from the component (1) is guided by the second holding fixture (5) over a support.

5. The device according to claim 3 or 4, wherein
the magnetic arrangement (8; 8*; 8**) is positioned at least partly in a receiving device of the support provided for this.

6. The device according to any one of the previous claims,
further comprising a first actuator (12), which is configured and arranged to move and/or to swivel the first holding fixture (4), and/or
further comprising a second actuator (13), which is configured and arranged to move and/or to swivel the second holding fixture (5).

7. The device according to any one of the previous claims,
further comprising a first sensor (14), in particular an imaging sensor, which is configured and arranged to determine a position of the component (1) on the carrier (2) directly and/or by detecting a reference marking (15), and/or
further comprising a second sensor (16), in particular an imaging sensor, which is configured and arranged to determine a position of the component (1) on the substrate (3) directly and/or by detecting a reference marking (17).

8. The device according to any one of claims 2 to 7,
further comprising at least one programmable control unit with a memory function (18), which is configured
to evaluate and/or store the information of the first sensor (14) according to claim 8, and/or
to evaluate and/or store the information of the second sensor (16) according to claim 8, and/or
to control the first actuator (12) according to claim 7, and/or
to control the second actuator (13) according to claim 7, and/or
to control each mirror positioning actuator (21) of the mirror arrangement (20) according to claim 7 independently of one another in each case, and/or
to control the intensity of the heat source (7; 7**) according to claim 6, and/or
to control each magnet adjustment or positioning device (19) according to claim 2 independently of one another in each case, and/or
to control a power supply (22) for each electromagnet (8*; 8**) according to claim 2 independently of one another in each case.

9. A method for transferring at least partly ferromagnetic electronic components (1) from a dispensing carrier (2) to a receiving substrate (3), wherein the method is **characterized by** the following steps:
- providing at least partly ferromagnetic electronic components (1) on the side of the carrier (2) facing the substrate (3),
- positioning the carrier (2) by a first holding fixture (4) at a predetermined distance from a second holding fixture (5) for the substrate (3) and in relation to a detachment unit (7; 7**) for the components (1);
- detaching one of the components (1) in each case from the carrier (2), at least supported by the detachment unit (7; 7**), in order to transfer the respective component (1) from the carrier (2) to a place (6) predetermined for this on the substrate (3), wherein the detachment unit (7; 7**) is a laser controllable in its intensity for detaching the components (1) attached to the carrier (2) from the carrier (2),
- providing a mirror arrangement (20) of one or more movable mirrors and at least one mirror positioning actuator (21), and
- moving and/or swivelling at least a single mirror of the mirror arrangement (20) by means of the mirror positioning actuator (21) to reflect an emitted laser beam of the detachment unit (7; 7**).
- attracting the at least partly ferromagnetic electronic component (1) by a magnetic attraction force, which is exerted by a magnetic field (9, 9*, 9**) on the component (1), wherein the magnetic field (9, 9*, 9**) is produced by a magnetic arrangement (8; 8*; 8**), which is positioned relative to the substrate (3) located in the second holding fixture (5) so that the magnetic attraction force at least supports a placement of the component (1) on the place (6) predetermined for this on the substrate (3);
- receiving the component (1) at the place (6) predetermined for this on the substrate (3), which is positioned by the second holding fixture (5).

10. The method according to claim 9,
wherein the magnetic arrangement is formed by one or more magnets and/or electromagnets (8; 8*; 8**), and/or
wherein at least one magnet of the magnetic arrangement (8**) is moved and/or swivelled by at least one magnet adjustment or positioning device (19).

11. The method according to one of claims 9 to 10,
wherein the first holding fixture (4) is moved and/or swivelled by a first actuator (12), and/or
wherein the second holding fixture (5) is moved and/or swivelled by a second actuator (13).

12. The method according to any one of claims 9 to 11,
further comprising a first sensor (14), in particular an imaging sensor, which determines a position of the component (1) on the carrier (2) directly and/or by detecting a reference marking (15), and/or
further comprising a second sensor (16), in particular an imaging sensor, which determines a position of the component (1) on the substrate (3) directly and/or by detecting a reference marking (17).

13. The method according to any one of claims 9 to 12,
further comprising at least one programmable control unit with a memory function (18), which
evaluates and/or stores the information of the first sensor (14) according to claim 12, and/or
evaluates and/or stores the information of the second sensor (16) according to claim 12, and/or
controls the first actuator (12) according to claim 11, and/or
controls the second actuator (13) according to claim 11, and/or
controls each mirror positioning actuator (21) according to claim 11 independently of one another in each case, and/or
controls the intensity of the laser according to claim 1, and/or
controls each magnet adjustment or positioning device (19) according to claim 10 independently of one another in each case, and/or
controls a power supply (22) for each electromagnet (8*; 8**) according to claim 10 independently of one another in each case.

## Revendications

1. Dispositif pour transférer des composants électroniques au moins partiellement ferromagnétiques (1) d'un support distributeur (2) à un substrat récepteur (3), le dispositif comprenant :
un premier logement (4) pour le support distributeur (2), qui est conçu et agencé pour tenir à disposition des composants électroniques au moins partiellement ferromagnétiques (1) sur le côté du support tourné vers le substrat (3), le premier logement étant situé à une distance prédéterminée
un deuxième logement (5) pour le substrat récepteur (3), qui est conçu et agencé pour recevoir un des composants (1) à un emplacement (6) prédéterminé à cet effet sur le substrat (3), et
une unité de détachement (7, 7**) qui est conçue et agencée pour au moins assister un détachement respectivement de l'un des composants (1) du support (2) afin de le transférer sur le substrat (3), ainsi que
un agencement d'aimants (8 ; 8* ; 8**) qui doit être positionné par rapport au deuxième logement (5) pour le substrat (3) de telle sorte que, au moins pendant le transfert du composant (1), un champ magnétique (9 ; 9* ; 9**) qu'il produit exerce une force d'attraction magnétique, dirigée du support (2) vers le substrat (3), sur le composant (1), la force d'attraction assistant au moins un placement du composant (1) à l'emplacement (6) prédéterminé à cet effet sur le substrat (3),
**caractérisé en ce que**
l'unité de détachement (7 ; 7**) pour détacher du substrat (2) les composants (1) fixés sur le substrat (2) est un laser dont l'intensité peut être commandée, et
un agencement de miroirs (20) formé d'un ou de plusieurs miroirs mobiles et au moins un actionneur de positionnement de miroir (21) sont prévus, l'actionneur de positionnement de miroir (21) étant conçu pour déplacer et/ou faire pivoter au moins un miroir individuel de l'agencement de miroirs (20) afin de réfléchir un faisceau laser émis par l'unité de détachement (7 ; 7**).

2. Dispositif selon la revendication 1, dans lequel
l'agencement d'aimants (8 ; 8* ; 8**) comprend un ou plusieurs aimants permanents et/ou électroaimants, et/ou
comprenant en outre au moins un moyen de réglage ou de positionnement d'aimant (19) qui est conçu et agencé pour déplacer et/ou faire pivoter au moins un aimant de l'agencement d'aimants (8**).

3. Dispositif selon la revendication 1, dans lequel
le deuxième logement (5) pour le substrat (3) est conçu et agencé pour déplacer le substrat (3) de manière successive ou continue par rapport au premier logement (4) pour le support distributeur (2), dans lequel
le substrat (3) présente une pluralité d'emplacements (6) prédéterminés pour recevoir des composants (1).

4. Dispositif selon la revendication 3, dans lequel
le côté du substrat (3) opposé au composant (1) est guidé par le deuxième logement (5) au-dessus d'un élément d'appui.

5. Dispositif selon la revendication 3 ou 4, dans lequel
l'agencement d'aimants (8 ; 8* ; 8**) est positionné au moins partiellement dans un moyen de réception prévu à cet effet de l'élément d'appui.

6. Dispositif selon l'une des revendications précédentes,
comprenant en outre un premier actionneur (12) qui est conçu et agencé pour déplacer et/ou faire pivoter le premier logement (4), et/ou
comprenant en outre un deuxième actionneur (13) qui est conçu et agencé pour déplacer et/ou faire pivoter le deuxième logement (5).

7. Dispositif selon l'une des revendications précédentes,
comprenant en outre un premier capteur (14), en particulier un capteur d'image, qui est conçu et agencé pour déterminer une position du composant (1) sur le support (2) directement et/ou en détectant une marque de référence (15), et/ou
comprenant en outre un deuxième capteur (16), en particulier un capteur d'image, qui est conçu et agencé pour déterminer une position du composant (1) sur le substrat (3) directement et/ou en détectant une marque de référence (17).

8. Dispositif selon l'une des revendications 2 à 7,
comprenant en outre au moins une unité de commande programmable avec fonction de mémoire (18), qui est conçue pour
évaluer et/ou stocker les informations du premier capteur (14) selon la revendication 8, et/ou
évaluer et/ou stocker les informations du deuxième capteur (16) selon la revendication 8, et/ou
commander le premier actionneur (12) selon la revendication 7, et/ou commander le deuxième actionneur (13) selon la revendication 7, et/ou
commander chaque actionneur de positionnement de miroir (21) de l'agencement de miroirs (20) selon la revendication 7 indépendamment l'un de l'autre, et/ou
commander l'intensité de la source de chaleur (7 ; 7**) selon la revendication 6, et/ou
commander chaque moyen de réglage ou de positionnement d'aimant (19) selon la revendication 2 indépendamment l'un de l'autre, et/ou
commander une alimentation électrique (22) pour chaque électroaimant (8* ; 8**) selon la revendication 2 indépendamment l'un de l'autre.

9. Procédé pour transférer des composants électroniques au moins partiellement ferromagnétiques (1) d'un support distributeur (2) à un substrat récepteur (3), le procédé étant **caractérisé par** les étapes suivantes :
- mise à disposition de composants électroniques au moins partiellement ferromagnétiques (1) sur le côté du support (2) tourné vers le substrat (3),
- positionnement du support (2) au moyen d'un premier logement (4) à une distance prédéterminée d'un deuxième logement (5) pour le substrat (3) et par rapport à une unité de détachement (7, 7**) pour les composants (1) ;
- détachement respectivement de l'un des composants (1) du support (2), au moins avec l'assistance de l'unité de détachement (7 ; 7**), afin de transférer le composant (1) correspondant du support (2) à un emplacement (6) prédéterminé à cet effet sur le substrat (3), l'unité de détachement (7 ; 7**) étant un laser, dont l'intensité peut être commandée, pour détacher du substrat (2) les composants (1) fixés sur le support (2),
- mise à disposition d'un agencement de miroirs (20) formé d'un ou de plusieurs miroirs mobiles et au moins un actionneur de positionnement de miroir (21), et
- déplacement et/ou pivotement d'au moins un miroir individuel de l'agencement de miroirs (20) au moyen de l'actionneur de positionnement de miroir (21) afin de réfléchir un faisceau laser émis par l'unité de détachement (7 ; 7**),
- attraction du composant électronique au moins partiellement ferromagnétique (1) par une force d'attraction magnétique qui est exercée sur le composant (1) par un champ magnétique (9, 9*, 9**), le champ magnétique (9, 9*, 9**) étant produit par un agencement d'aimants (8 ; 8* ; 8**) qui est positionné par rapport au substrat (3) situé dans le deuxième logement (5) de telle sorte que la force d'attraction magnétique assiste au moins un placement du composant (1) à l'emplacement (6) prédéterminé à cet effet sur le substrat (3) ;
- réception du composant (1) à l'emplacement (6) prédéterminé à cet effet sur le substrat (3) qui est positionné par le deuxième logement (5).

10. Procédé selon la revendication 9,
dans lequel l'agencement d'aimants est formé d'un ou de plusieurs aimants et/ou électroaimants (8 ; 8* ; 8**), et/ou
dans lequel au moins un aimant de l'agencement d'aimants (8**) est déplacé et/ou pivoté par au moins un moyen de réglage ou de positionnement d'aimant (19).

11. Procédé selon l'une des revendications 9 à 10,
dans lequel le premier logement (4) est déplacé et/ou pivoté par un premier actionneur (12), et/ou
dans lequel le deuxième logement (5) est déplacé et/ou pivoté par un deuxième actionneur (13).

12. Procédé selon l'une des revendications 9 à 11,
comprenant en outre un premier capteur (14), en particulier un capteur d'image, qui détermine une position du composant (1) sur le support (2) directement et/ou en détectant une marque de référence (15), et/ou
comprenant en outre un deuxième capteur (16), en particulier un capteur d'image, qui détermine une position du composant (1) sur le substrat (3) directement et/ou en détectant une marque de référence (17).

13. Procédé selon l'une des revendications 9 à 12,
comprenant en outre au moins une unité de commande programmable avec fonction de mémoire (18), qui
évalue et/ou stocke les informations du premier capteur (14) selon la revendication 12, et/ou
évalue et/ou stocke les informations du deuxième capteur (16) selon la revendication 12, et/ou
commande le premier actionneur (12) selon la revendication 11, et/ou
commande le deuxième actionneur (13) selon la revendication 11, et/ou
commande chaque actionneur de positionnement de miroir (21) selon la revendication 11 indépendamment l'un de l'autre, et/ou
commande l'intensité du laser selon la revendication 1, et/ou
commande chaque moyen de réglage ou de positionnement d'aimant (19) selon la revendication 10 indépendamment l'un de l'autre, et/ou
commande une alimentation électrique (22) pour chaque électroaimant (8* ; 8**) selon la revendication 10 indépendamment l'un de l'autre.
